(19) Europäisches Patentamt
European Patent Office
Office européen des brevets

(11) **EP 3 385 728 B1**

(12) **EUROPEAN PATENT SPECIFICATION**

(45) Date of publication and mention
of the grant of the patent:
**22.06.2022 Bulletin 2022/25**

(21) Application number: **17165083.1**

(22) Date of filing: **05.04.2017**

(51) International Patent Classification (IPC):
***G01R 23/10*** *(2006.01)*      ***G01R 31/317*** *(2006.01)*

(52) Cooperative Patent Classification (CPC):
**G01R 23/10; G01R 31/31727**

(54) **AN AUTOMOTIVE SAFETY ELECTRONIC CONTROL SYSTEM**

**ELEKTRONISCHES AUTOMOBILSICHERHEITSSTEUERUNGSSYSTEM**

**SYSTÈME DE COMMANDE ÉLECTRONIQUE DE SÉCURITÉ AUTOMOBILE**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**10.10.2018 Bulletin 2018/41**

(73) Proprietor: **Veoneer Sweden AB**
**447 83 Vårgårda (SE)**

(72) Inventors:
• **JEANNARD, Jean-Francois**
**78700 Conflans Sainte Honorine (FR)**

• **LECHAUX, Thomas**
**95000 Neuville sur Oise (FR)**

(74) Representative: **Mewburn Ellis LLP**
**Aurora Building**
**Counterslip**
**Bristol BS1 6BX (GB)**

(56) References cited:
**JP-A- H 103 324          US-A1- 2006 132 190
US-A1- 2013 191 065**

**Description**

The present invention relates to an electronic control system, and more particularly relates to a vehicle safety electronic control system.

Electronic safety systems are now very widely used in motor vehicles. Such safety systems may include, for example: blind spot monitoring systems; active cruise control systems; pre-safe braking systems; collision avoidance systems; lane departure prevention systems; and rear-collision mitigation systems.

The complex nature of modern vehicular safety systems places great importance on the performance and reliability of the electronic control systems which are required to provide and manage the safety systems. Such control systems typically include integrated hardware and software in order to host and run so-called Advanced Driver Assistance Systems (ADAS) algorithms.

Such systems are required to satisfy very stringent safety requirements such as the ISO 26262 Functional Safety for Road Vehicles standard, which defines a so-called Automotive Safety Integrity Level (ASIL) risk classification scheme. ASIL-D represents the highest integrity requirements under this standard, and is applicable to safety-related processing tasks.

A requirement of the functional safety standard is that the control system must be capable of identifying safety-relevant errors in its arithmetic, logical and memory units, which is only possible for an ASIL-D electronic control unit if a lockstep processor architecture is used. However, processors with a lockstep architecture of this type have a relatively low processing power, which is insufficient to handle modern applications like ADAS with a set of suitable sensors such as Radar, Lidar and/or cameras. It has therefore been proposed to use electronic control units (ECUs) comprising at least two microcontrollers, such that a first so-called "safety" microcontroller can handle important safety-related tasks and monitor the operation of a second so-called "performance" microcontroller which has a higher processing power and is thus configured to handle the main processing tasks of the system, under the supervision of the safety microcontroller. In these types of arrangements, the safety microcontroller is thus usually configured to operate as a so-called "master" microcontroller, and the performance microcontroller is usually configured to operate as a so-called "slave" microcontroller.

As will be appreciated, a typical modern ADAS system will be configured to perform various different functions (e.g. blind spot monitoring; active cruise control; pre-safe braking; collision avoidance; lane departure prevention etc.), and so the system architecture will usually include a plurality of multi-core microcontrollers. The ADAS system will furthermore comprise a number of communication buses to interconnect the various components, including a plurality of sensors and the microcontrollers, of the system. These communication buses may include a FlexRay serial bus, a Controller Area Network ("CAN") bus, and an Ethernet bus.

As well as automotive safety, such systems may also be used in an autonomous driving control system. Evidently, safe operation of an autonomous driving control system is of paramount importance. Errors or unpredictable/incorrect behaviour of an autonomous driving system may prove extremely dangerous. It is thus important that an autonomous driving system is extremely stable in its operation, and is able to identify and solve errors within the system quickly and decisively. Similarly, to automotive safety, the computing power required for an autonomous driving control system is high. As such, an autonomous driving control system may also include a number of processors configured to distribute the computing load, for example in a master and slave configuration.

In general, central processing units (CPUs), graphical processing units (GPUs), Field Programmable Gate Arrays (FPGAs), Complex Programmable Logic Devices (CPLD), microcontrollers (MCUs), registers, and digital electronics in general, include elements that work in a stepwise manner. With each step, transitions are made between logical states. On a macro level, these changes amount to processing data, for example performing calculations, changing variable values, changing outputs etc.

The regularity and frequency of the steps in the step-wise operation of digital electronics are controlled by a clock signal. A clock signal is usually a waveform that transitions repeatedly and regularly between logical states 0 and 1. A single clock cycle corresponds to the waveform repeating once (i.e. the time between two adjacent transitions from logical 0 to logical 1). The clock period is the time taken for a single clock cycle to take place. The clock frequency is the inverse of the clock period. Typically, a clock signal will spend approximately half the time in a logical 1 state and approximately half the time in a logical 0 state. The time taken in transitioning between these states is generally minimized. The waveform of a clock signal is therefore typically a square wave.

A clock signal is often ultimately derived from a crystal oscillator circuit. A crystal oscillator circuit uses a vibrating crystal of piezoelectric material to create an oscillating electronic signal. There may be further modification of this electronic signal, for example, square-wave generation, and/or frequency multiplication. Ultimately, however, the frequency of the clock signal is dictated by the vibration frequency of the crystal. The vibration frequency of the crystal is not necessarily stable. For example, the vibration frequency (and accordingly the clock frequency derived therefrom) may depend on temperature.

A clock source may also include a phase locked loop (PLL). A PLL is a control system that produces an oscillating output signal with a phase that is related to the phase of an oscillating input signal. A PLL may also be used to produce an output signal with a frequency that is a multiple of the frequency of input signal. Thus, a PLL can be used to produce a clock signal with a clock frequency that is different from the vibration frequency of a crystal oscillator supplying the input signal to the PLL.

As well as the clock signal being used to control the absolute regularity and frequency of the steps in the operation of digital electronics, a clock signal can also be used to synchronise the relative operation of distinct electronic elements. Such synchronization can be particularly important where there is communication between the electronic elements.

A clock frequency of a clock signal is measured in cycles-per-second, with SI units of Hertz. For a typical personal computer-type central processing unit (CPU), example clock frequencies are 1-3 GHz. For an FPGA, an example clock frequency is approximately 400MHz. For a CPLD, an example clock frequency is approximately 100MHz.

Because the steps taken by a processor occur at a rate and phase dictated by a clock signal, it is important that the clock signal has a constant, predictable, and stable clock signal. In other words, the frequency and phase of the clock signal should be constant.

A processor, for example, typically uses a clock signal of a fixed frequency. If that fixed frequency changes, then the processor may cease to work as desired, or may produce unpredictable and incorrect results. Alternatively, the processor may simply work faster or slower in accordance with the change in clock frequency. Such a change in processing speed may mean that the processor is then out of synchronisation with other elements in a computing system in which it resides. In the context of automotive safety and autonomous driving, a processor that gives unpredictable, incorrect or unsynchronised results can present a safety risk.

For a given element of digital electronics (for example, a processor or an MCU) a tolerance in clock frequency may be defined. The tolerance corresponds to the change in clock frequency from a nominal value beyond which the element will cease to operate correctly, or cease to interact properly with other elements of a system. If a clock frequency is beyond the tolerance (i.e. above a maximum clock frequency or below a minimum clock frequency), then the element may cease to work correctly, cease to operate completely, overheat, or cease to interact with other elements properly or safely, for example.

An automotive safety system may have two or more processors for example, that are interacting in some way. For example, a system may have a master processor delegating some functionality and/or processing to at least one slave processor. To perform this delegation, and to collect the results of the processing by the at least one slave processor, communication is necessary between the master processor and the at least one slave processor. For this communication to take place, the clock frequency of the clock signal applied to each of the processors must be within the individual clock tolerances of the respective processor and the relative synchronisation between the processors must be within a relative tolerance. For example, the intention may be that the clock frequency of the slave processor is equal to the clock frequency of the master processor.

It is therefore important to know when a clock signal has drifted. Such a drift may be within the individual tolerance of the processor to which the clock is applied, so that processor may appear to be working correctly. However, the processor may not be communicating correctly with other processors in a system. In general, it is important to identify if the clock frequency for a slave processor is within a specified tolerance with respect to the clock frequency of a master processor.

US 2013/191065 discloses a clock fault detector.

It is an object of the present invention to provide an improved automotive safety electronic control system.

According to the present invention, there is provided an automotive safety electronic control system, comprising: a processor including a processor clock, wherein the processor is configured to output a cyclic test clock signal representative of the processor clock; a reference clock source configured to output a cyclic reference clock signal, and; a test device; wherein the test device is configured to: include a test counter, the test counter configured to count a number of cycles of the test clock signal, and to store a test count value representing a number of test count cycles; include a reference counter, the reference counter configured to count a number of cycles of the reference clock signal, and to store a reference count value representing a number of reference count cycles, and; modify the test count value upon receipt by the test device of each cycle of the test clock signal; modify the reference count value upon receipt by the test device of each cycle of the reference clock signal, and; calculate a difference between the test count value and the reference count value.

Optionally, the modification of the reference count value and the modification of the test count value are both an increment operation or are both a decrement operation.

Advantageously, the test device is configured to calculate the difference between the test count value and the reference count value when the reference count value is equal to a predetermined trigger value.

Conveniently, the test device is configured to output an error signal when the absolute value of the difference between the test count value and the reference count value is greater than a predetermined error threshold.

Preferably, the processor is configured to perform an error recovery routine in response to the error signal.

Advantageously, the test count value changes between a minimum value and a maximum value, and the reference count value changes between the minimum value and the maximum value.

Conveniently, the test device includes a first input pin for receipt of the test clock signal; a second input pin for the receipt of reference clock signal; a reset pin for resetting the test device; and an error pin for outputting the error signal.

Preferably, the test device is a programmable logic device.

Advantageously, the programmable logic device is a Complex Programmable Logic Device ("CPLD") or a Field-Programmable Gate Array ("FPGA").

Conveniently, the processor is a slave processor operatively connected to a master processor, and wherein the reference clock source is included within the master processor.

Preferably, the processor is a slave processor operatively connected to a master processor, wherein a processor reference clock source is included within the master processor and an oscillator reference clock source is a local oscillator, and wherein the test device is configured to use interchangeably the processor reference clock source or the oscillator reference clock source as the reference clock source.

Advantageously, the difference between the test count value and the reference count value represents a difference in the clock frequency of the processor clock and a clock frequency of the reference clock.

Conveniently, the automotive safety electronic control system further includes at least one further processor; each further processor including a respective clock, wherein each further processor is configured to output a respective cyclic test clock signal representative of the respective clock; and wherein the test device is further configured to: include at least one further test counter, the further test counter configured to count a number of cycles of the respective test clock signal, and to store a further test count value representing a number of further test count cycles; modify each further test count value upon receipt of each cycle of the respective test clock signal; calculate a difference between each respective test count value and the reference count value.

Preferably, the test device is configured to output a respective error signal if the difference between a respective test count value and the reference count value is greater than a respective error threshold.

Advantageously, each respective slave processor is configured to receive the respective error signal, and, upon receipt of the respective error signal, perform an error recovery routine.

So that the invention may be more readily understood, and so that further features thereof may be appreciated, embodiments of the invention will now be described by way of example with reference to the accompanying drawings in which:

Figure 1A is a schematic view of a processor;

Figure 1B is a schematic view of an alternative processor;

Figure 2 is a schematic view of two processors in a master and slave configuration;

Figure 3 is a schematic view of an automotive safety system according to an embodiment;

Figure 4 is a plot illustrating a first scenario of the operation of the automotive safety system shown in figure 3;

Figure 5 is a plot illustrating a second scenario of the operation of the automotive safety system shown in figure 3;

Figure 6 is a plot illustrating a third scenario of the operation of the automotive safety system shown in figure 3; and

Figure 7 is a plot illustrating a fourth scenario of the operation of the automotive safety system shown in figure 3.

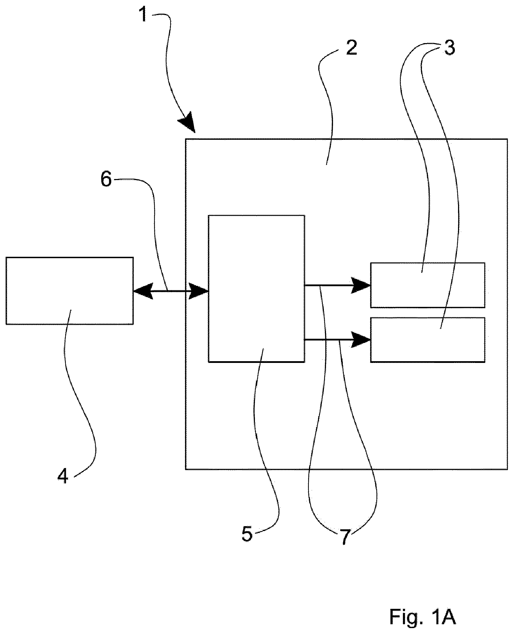

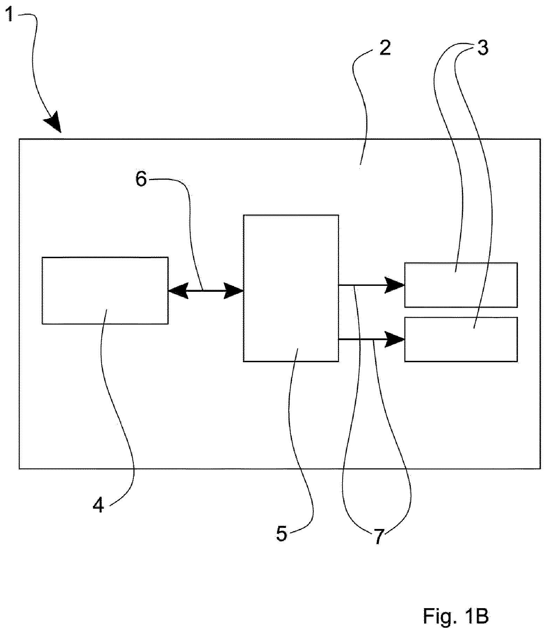

Figure 1A shows a processor 1. The processor 1 includes a microcontroller (MCU) 2, which in turn includes two processor cores 3 ("cores"). The processor 1 is therefore described as "multicore". It will be understood that the MCU 2 may have a different number of cores, for example 1, 2, 4, 8, 16 cores etc. The processor 1 includes an oscillator 4. In the processor 1 shown in figure 1, the oscillator 4 is external to the MCU 2. The oscillator 4 produces and outputs an oscillating electronic signal. The oscillator 4 may include a crystal oscillator circuit to produce the oscillating electronic signal. The MCU 2 includes a Phase Locked Loop circuit (PLL) 5. There is an oscillator connection 6 between the oscillator 4 and the PLL 5. The oscillator connection 6 allows the oscillating electronic signal to be input to the PLL 5 from the oscillator 4. The oscillator connection 6 may be directly between an output pin on the oscillator 4 and an input pin on the PLL 5. Alternatively, the oscillator connection 6 may be between an output pin on the oscillator 4 and an input pin of the MCU 2, which is in turn connected to an input of the PLL. As will be appreciated, the oscillator connection 6 need not be a direct connection between the oscillator 4 and the PLL 6. What is important is that the oscillating electronic signal is transmitted from the oscillator 4 to the PLL 5.

The PLL 5 multiplies the frequency of the oscillator signal (which is input to the PLL 5 via the oscillator connection 6). The PLL 5 could alternatively divide the frequency of the oscillating electronic signal. The PLL 5 produces a square-wave oscillating clock signal. The clock signal is transmitted to each of the two cores 3 via a respective clock-core connection 7. The two separate clock-core connections 7 may carry identical signals. Whilst the clock-core connections are shown as distinct in figure 1A, they could equally be formed as a single output from the PLL, which splits to connect to each of the cores. The connection between the PLL and the cores may be direct or indirect, but what is important is that the clock signal is transmitted to each of the cores.

Figure 1B shows an alternative structure for a processor 1 to that shown in figure 1A. Detailed description of the structure is omitted where it is similar to the processor shown in figure 1A. The difference between the structure of processor 1 shown in figure 1A and the processor shown in figure 1B is the location of the oscillator 4. In the processor of figure 1B, the oscillator 4 is located within the MCU 2. In other words, the MCU 2 shown in figure 1B produces its own clock signal using the oscillator 4 within. The oscillator connection 6 between the oscillator 4 and the PLL 5 exists in the arrangement of figure 1B, just as it does in the arrangement of figure 1A. The oscillator connection 6 is implemented inside the MCU 2.

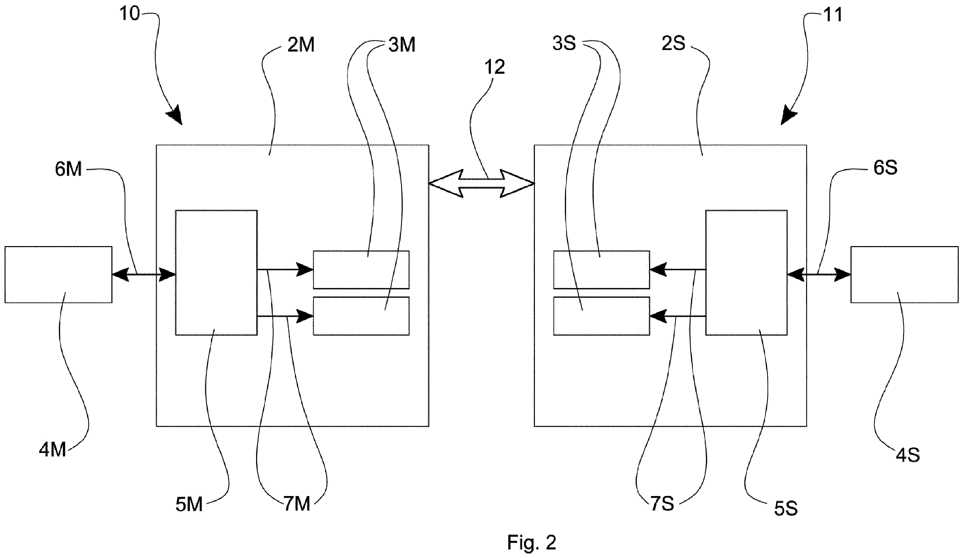

Figure 2 shows a master processor and a slave processor in a master and slave configuration.

The configuration of the master processor 10 is in general similar to the processor shown in figure 1A. Like elements have the same reference numerals in figure 2 as they do in figure 1A, suffixed with an "M". The configuration of the slave processor 11 is in general similar to the processor shown in figure 1A. Like elements have the same reference numerals in figure 2 as they do in figure 1A, suffixed with an "S".

The slave MCU 2S is operatively connected to the master MCU 2M via an operative connection 12. The operative connection 12 is a two-way connection. In general, the master MCU 2M controls the operation of the slave MCU 2S. This control is achieved via the operative connection 12. The operative connection 12 allows the passing of information between the master MCU 2M and the slave MCU 2S, and vice-versa. The information may include data, signalling, and the results of calculations, for example. The master MCU 2M may be configured to delegate processing tasks to the slave MCU 2S, sending instructions to the slave MCU 2S via the operative connection 12. The slave MCU 2S then performs the processing task, and sends the results to the master MCU 2M, via the operative connection 12. The operative connection 12 may comprise a number of individual connections or channels, each individual connection or channel being between the master MCU 2M and the slave MCU 2S.

The master processor 10 has a master oscillator 4M, and the slave processor 11 has a slave oscillator 4S. The master oscillator 4M is separate and distinct from the slave oscillator 4S. The master oscillator 4M produces and outputs a master oscillating electronic signal and the slave oscillator 4S produces and outputs a slave oscillating electronic signal. The frequency of the master oscillating electronic signal may not be the same as the frequency of the slave oscillating electronic signal.

The digital step-wise operation of the master MCU 2M is ultimately dictated by the frequency of the master oscillating electronic signal from the oscillator 4M, via the master PLL 5M. Similarly, the digital step-wise operation of the slave MCU 2S is ultimately dictated by the frequency of the slave oscillating electronic signal from the oscillator 4S, via the slave PLL 5S.

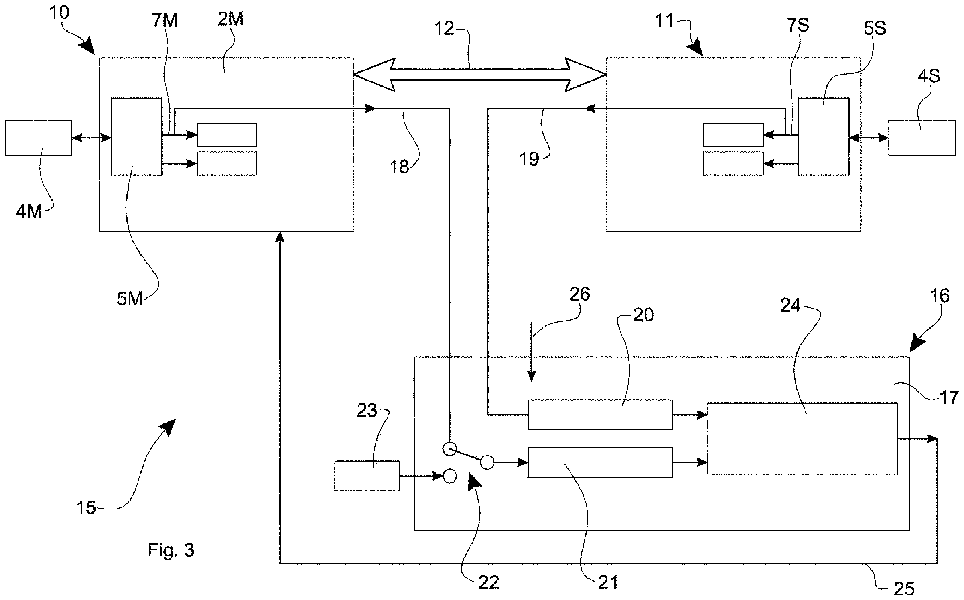

Figure 3 shows an automotive safety electronic control system 15 according to an embodiment of the invention. The automotive safety electronic control system 15 includes a master processor 10 and a slave processor 11. The automotive safety electronic control system 15 also includes a test system 16. The test system 16 includes a test device 17. The test device 17 may, for example, be a Complex Programmable Logic Device (CPLD), a Field Programmable Gate Array (FPGA), an MCU, or an Application Specific Integrated Circuit (ASIC).

A master clock signal line 18 of the master PLL 5M is output from the master processor 10. The master clock signal line 18 carries the master clock signal. The master clock signal line 18 is branched from one of the master clock-core connections 7M, in the embodiment shown in figure 3. However, the skilled person will appreciate that there are a number of alternative ways to output the master clock signal from the master processor 10.

A slave clock signal line 19 from the slave PLL 5S is output from the slave processor 11. The slave clock signal line 19 carries the slave clock signal. The slave clock signal line 19 is branched from one of the slave clock-core connections 7S, in the embodiment shown in figure 3. However, the skilled person will appreciate that there are a number of alternative ways to output the slave clock signal from the slave processor 11.

The master clock signal line 18 and the slave clock signal line 19 are each connected to the test device 17. The test device 17 includes a test counter 20 and a reference counter 21. It will be appreciated the test counter 20 and the reference counter 21 may be intangible functionalities that are implemented in electronics, either permanently (as in an ASIC) or temporarily (as in a CPLD or FPGA). In any case, the test counter 20 and reference counter 21 each have the ability to store a number, the number corresponding to a test count value and reference count value, respectively. The test counter 20 and the reference counter 21 are also each configured to be able to increase or decrease their respective count value.

The test device 17 includes a switch 22. The switch 22 is configured to selectively couple potential reference clock sources into the test device 17 and ultimately into the reference counter 21. In the embodiment shown in figure 3, the switch 22 is connected to two potential reference clock sources - the master clock signal line 18 and an external clock source 23. The switch is able to select between the external clock source 23 and the master clock signal line 18. For example, if the master MCU 2M is not able to provide a master clock signal for any reason, then the switch 22 can be used to couple the external clock source 23 to the test device 17 as the reference clock source.

It will be appreciated that the switch 22 may be omitted entirely. Instead, the reference counter may be directly connected to an external clock, to the master clock signal line, or to another clock source.

In the embodiment shown in figure 3, the test counter 20 is configured to decrement the reference count value stored therein by one with each complete cycle of the slave clock signal received via the test clock signal line 19. Similarly, the reference counter 21 is configured to decrement the reference count value stored therein by with each complete cycle of the master clock signal received via the master clock signal line 18 or the external clock source 23 (depending on the state of the switch 22).

The test count value may initially be equal to $N\_test\_max$ (a maximum value for the test count value), and the minimum value may be equal to zero. It will be appreciated that the test count value stored in the test counter will decrease from $N\_test\_max$ to zero in increments of one as successive cycles of the test clock signal are received by the test counter 20. When the test count value is equal to zero and a further cycle of the test clock signal is received by the test counter 20, then the test count value returns to $N\_test\_max$. The process of decrementing the test count value then begins again towards zero. The test count value stored in the test counter therefore cycles between $N\_test\_max$ and zero.

Similarly, the reference count value may initially be $N\_ref\_max$ (a maximum value for the reference count value), and the minimum value may be equal to zero. It will be appreciated that the reference count value stored in the reference counter will decrease from $N\_ref\_max$ to zero in increments of one as successive cycles of the reference clock signal are received by the reference counter 21. When the reference count value is equal to zero and a further cycle of the reference clock signal is received by the reference counter 21, then the reference count value returns to $N\_ref\_max$. The process of decrementing the reference count value then begins again towards zero. The reference count value stored in the test counter therefore cycles between $N\_ref\_max$ and zero.

It will be appreciated that the test count value and the reference count value may alternatively be incremented with each cycle of the respective clock signals. In this case, the test count value would cycle between zero and $N\_test\_max$, and the reference count value would cycle between zero and $N\_ref\_max$.

The values stored in the reference count value and the test count value may each be stored as an n-bit digital representation of the value. As will be appreciated, if the value is stored as an unsigned, 16-bit integer, for example then the highest value that can be stored would be 65,535 (i.e. $N\_ref\_max$ or $N\_test\_max$), the minimum value would be zero. It will be apparent that there are a number of different ways of representing the test count value and the reference count value. The representation could equally be signed (as opposed to unsigned). The representation could alternatively be a floating-point number. What is important, is that the reference count value increases or decreases with the receipt of reference clock cycles, and the test count value increases or decreases with receipt of test clock cycles.

The test device 17 also includes a comparing device 24. It will be appreciated the comparing device 24 may also be an intangible element which is implemented in electronics, either permanently or temporarily (for example, in a FPGA, CPLD, or ASIC). Where the test device is an FPGA, which are based on SRAM, at each power ON of the test device, the FPGA needs to reconfigure its internal logic. The instructions for this reconfiguration are included in an internal or external (to the FPGA) ROM memory. The comparing device 24 is configured to carry out a comparison function. In the comparison function, the reference count value stored in the reference counter and the test count value stored in the test counter are compared with one another, and the difference between the two values is calculated. The difference may be a positive or negative integer, for example. The comparing device 24 is further configured to output an error signal to an error signal line 25 if the absolute magnitude of the difference is greater than a predetermined error threshold. The predetermined error threshold corresponds to a tolerance in the difference between the reference counter and the test counter. If the calculated difference does not exceed the predetermined error threshold, then the comparing device does not output an error signal.

The predetermined error threshold may be defined at the time of manufacture of the test device, or at the time of producing the instructions used to configure the test device. The predetermined error threshold may alternatively be a variable sent by the master MCU to the to the test device during a power on sequence.

The difference may be output from the comparing device. For example, the difference may be output from the comparing device to the slave processor and/or the master processor.

Pseudo-code that is implemented by the comparing device is as follows:

```
    if(abs(ref_count - test_count) > tol))
        then CLK_ERROR = 1;
    else CLK ERROR = 0;
```

where *ref_count* is the reference count value stored in the reference counter, *test_count* is the test count value stored in the test counter, *tol* is the predetermined error threshold, and *CLK ERROR* is a variable that indicates if an error has occurred. CLK_ERROR has a value of 1 (or TRUE) when an error has occurred, and a value of 0 (or FALSE) when an error has not occurred. Under normal, non-error state, conditions, *CLK ERROR* = FALSE. "abs()" indicates an absolute value function, or modulus function. The *abs* function returns the magnitude of the argument supplied to it. For example, abs(10) = 10; abs(-33) = 33.

The comparing device 24 is configured to perform the comparison function when the reference count value is equal to a predetermined trigger value. In the embodiment, the predetermined trigger value is equal to *N_ref_max.* However, this is merely an example. It will be appreciated that the comparing device could be configured to perform the comparison at any time.

Because the reference count value is incremented with each cycle of the reference clock, the rate of change of the reference count value is a proxy for the frequency of the reference clock. Similarly, the rate of change of the test count value is a proxy for the frequency of the test clock. The comparison between the reference count value and the test count value is therefore a proxy for a comparison between the frequencies of the test clock signal and the reference clock signal. If the frequency of the test clock is identical to the frequency of the reference clock, then the test count value and the reference count value will count-down at identical rates. As such, the difference between the two values will be equal to zero.

If the frequency of the test clock is not identical to the frequency of the reference clock, then when a comparison is made between the test count value and the reference count value, then the values will not be identical. The difference between the values is a proxy for the difference between the test clock frequency and the reference clock frequency.

For binary integer representations of the counters, the following drift formula applies:

$$\frac{\Delta f}{f} = \frac{\Delta \text{Counters}}{2^N}$$

Where *f* is the clock frequency of the reference clock, $\Delta f$ is the relative difference between the test clock frequency and the reference clock frequency, *ΔCounters* is the absolute value of the difference between *ref_count* and *test_count,* and *N* is the number of bits used to store the test count value or the reference count value.

It will be appreciated that the value of *N* dictates the relative accuracy of frequency drift that it is possible to detect in test clock frequency drift. For example,

• with 8-bit counters (*N* = 8) a 1% frequency drift can be identified;

• with 12 bit counters (*N* = 12) a 0.1% frequency drift can be identified;

• with 16-bit counters (*N* = 16) a 100 ppm (parts-per-million) frequency drift can be identified.

The comparing device 24 is configured to output a signal on the error signal line 25 according to the value of CLK_ERROR. As such, if the difference between the test count and the reference count exceeds the threshold error tolerance, then an error signal is output from the comparing device 24 on the error signal line 25. The error signal line 25 is connected to the master MCU 2M. This connection provides a feedback mechanism. The master MCU 2M can take action based on an error signal received on the error signal line 25. Specifically, the receipt of an error signal by the master MCU 2M may cause the master MCU execute an error recovery routine. For example, the error recovery routine may include the master MCU 2M instructing the slave MCU to reset slave oscillator 4S, or the master MCU 2M resetting the whole slave processor 11. Such a reset may bring the slave clock frequency back to its correct value. The error recovery routine may including disabling the slave processor, or preventing the master processor from using the slave processor. The error recovery routine may also include logging the occurrence of the error.

When the test clock frequency has drifted (for any reason), the test clock frequency may be outside a safe operating condition, for example outside a specified tolerance for the slave MCU 2S. Where such a drift occurs, the slave MCU 2S may perform calculations incorrectly, or; send erroneous information to the master MCU 2M, which could in turn present a safety risk. Where this is the case, the error signal may cause the master MCU 2M to reset or shutdown the slave MCU 2S or cause the slave MCU 2S to enter into a Safe State.

The test device includes a reset pin 26 for the receipt of a reset signal. When the test device receives a reset signal on the reset pin 26, the test device may reset itself to an initial state.

The test device may be reset after a powering on of the system, for example just after the master MCU and slave MCU are powered up and configured for operation. This may be important where the test device is a CPLD or FPGA that are based on registers with asynchronous reset inputs. In this case, it may be important to reset the test device (asynchronous reset) after the power on of the test device, to ensure that the logic in the test device is properly initialised.

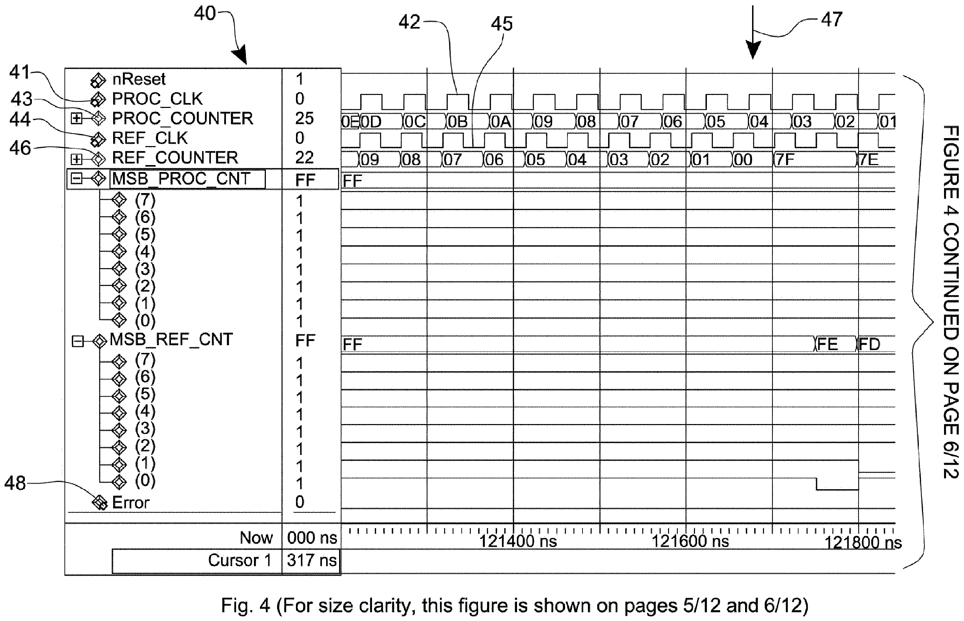

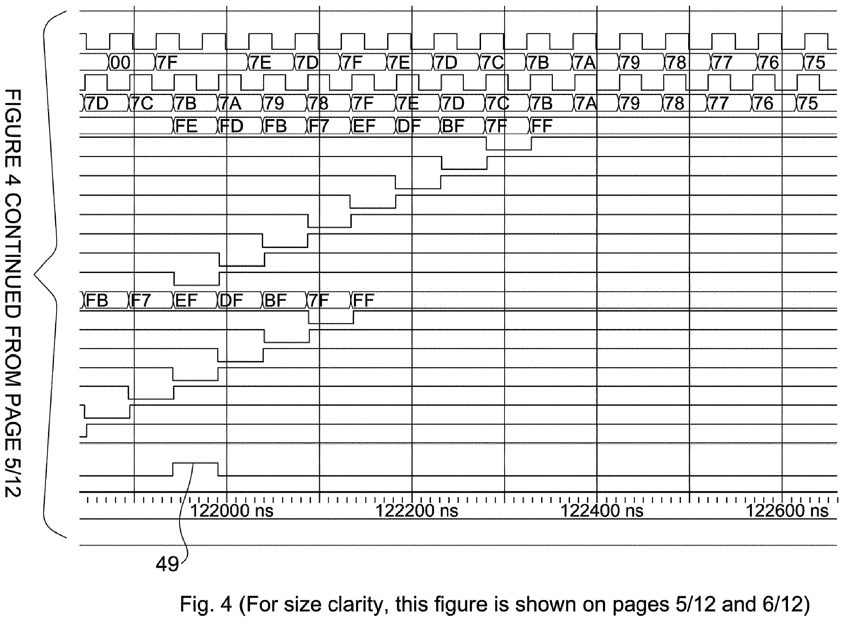

Figures 4 to 7 show four different scenarios for the comparison step as performed by the comparing device 24.

Figure 4 shows a visual representation of the comparison step and the variables involved in a first scenario.

The left hand column provides the names for the different lines of the plot 40. A separate y-axis for each variable (only showing whether the bit is 1 or 0) is shown. The labels for the different lines of the plot are indicated in the left hand column. Along the bottom, x-axis, time is represented.

The plot 40 includes a line corresponding to a chart 41 showing the "PROC_CLK", which is a visual representation of the test clock signal, which can been seen oscillating between 1 and 0 with a square wave profile 42. The plot 40 also includes a line showing a test sequence of test count values 43 (labelled "PROC_COUNTER"). Each test count value is shown as a hexadecimal representation of the binary state of the 8-bit test counter. As can be seen between chart 41 and test sequence 43, the test count value stored in the 8-bit test counter is decremented by one with each complete cycle of the test clock signal. As can be seen at around 121900 nanoseconds (as indicated on the x-axis), the value stored in the test counter rolls over from 0x00 to 0x7F. In other words, the binary content of the 8-bit value rolls over from 00000000 to 11111111.

The plot 40 includes a line corresponding to a chart 44 showing the "REF_CLK", which is a visual representation of the reference clock signal, which can been seen oscillating between 1 and 0 with a square wave profile 45. The plot 40 also includes a line showing a reference sequence 46 of reference count values (labelled "REF_COUNTER"). The reference count value is shown a hexadecimal representation of the binary state of the 8-bit reference counter. As can be seen between chart 44 and reference sequence 46, the reference count value stored in the 8-bit reference counter is decremented by one with each complete cycle of the reference clock signal. As can be seen at around 121650 nanoseconds (as indicated on the x-axis), the value stored in the reference counter rolls over from 0x00 to 0x7F. In other words, the binary content of the 8-bit value rolls over from 00000000 to 11111111.

When the reference count is equal to the predetermined trigger value, as indicated by the point in time 47, the difference between the reference count value and the test count value (as shown in sequences 43 and 46 on the plot 40) is calculated. In this embodiment, the predetermined trigger value is therefore equal to zero (0x00). It will be appreciated however that the trigger value could equally be any value that it is possible for the reference counter to take. As will be clear from the plot 40, at the point in time 47 at which the calculation is made, the test count value lags behind the reference count value by just over four (thus corresponding to four clock cycles). As such, in the notation of the pseudocode above, abs(*ref_count - test_count*) corresponds to abs(0 - 4) = +4. In this particular embodiment, the predetermined error threshold *(tol,* in the pseudocode above) is set to 3. abs(*ref_count - test_count*) is greater than *tol,* so CLK_ERROR is set to 1 (or TRUE) and an error signal is triggered on the error signal line.

Plot 40 includes an error chart 48, which is a visual representation of the signal on the error signal line. The signal on the error signal line is generally in a low, off, FALSE state, except at around 121950 nanoseconds, where an error signal 49 is output on the error signal line. The error signal corresponds to a period of time during which the signal on the error signal line is in a high, on, TRUE state. The error signal is triggered because the frequency drift is sufficiently high to cause a difference in the reference count value and test count values that is greater than the predetermined error threshold.

Using the equation above, we can determine that if $f = 20\text{MHz}$, $N = 8$, and $\Delta Counters = -4$, then we find that $\Delta f = 0.3125$ MHz. That is to say, the test clock frequency is (20 - 0.3125) MHz = 19.6875 MHz. In the first scenario, the test clock frequency offset is approximately - 1.5%, relative to the reference clock frequency.

In the described embodiment, the comparison is performed between the difference in the reference and test count values and a tolerance threshold value expressed as a number of counts. Alternatively, the actual reference clock frequency and test clock frequency may be calculated in terms of Hz, and the difference in those frequencies compared to a predetermined frequency drift tolerance (also in terms of Hz). The outcome of both approaches is identical, although an integer comparison may be more simply implemented in digital electronics, rather than a floating point comparison if the frequency in Hz is calculated before the comparison.

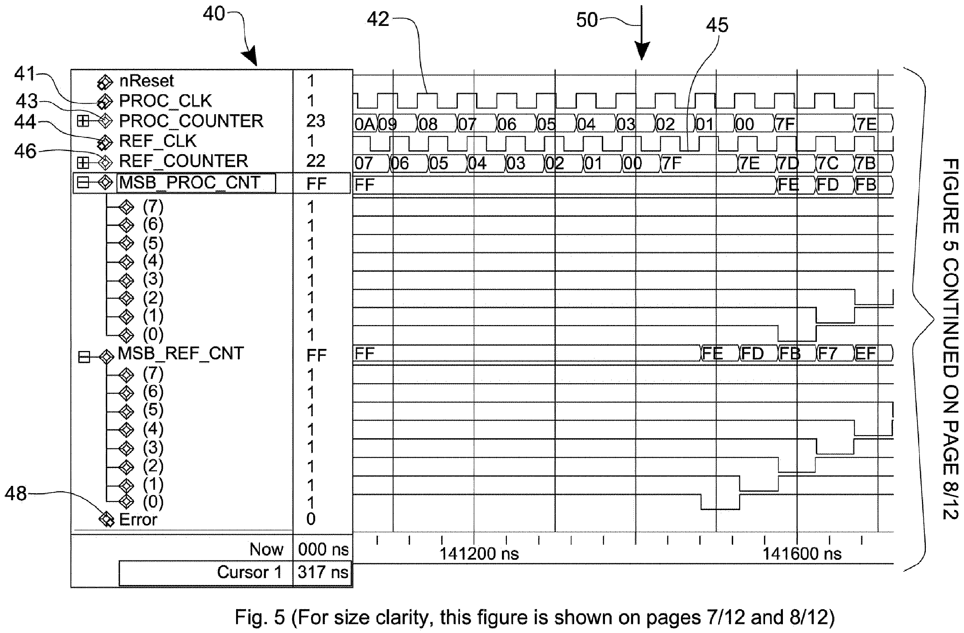

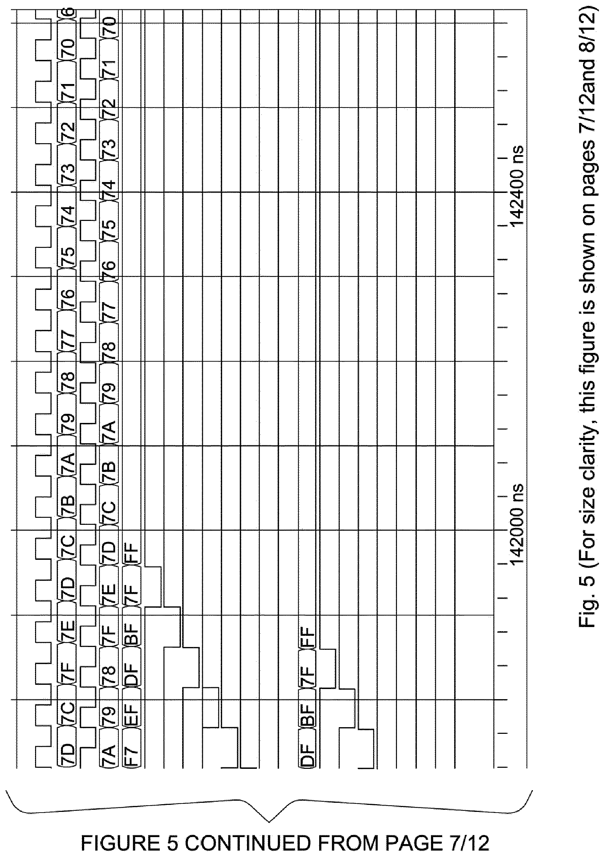

Figure 5 shows a visual representation of the comparison step and the variables involved in a second scenario. Like elements are labelled similarly to those shown in figure 4.

When the reference count is equal to the predetermined trigger value, as indicated by the point in time 50, the difference between the reference count value and the test count value (as shown in sequences 43 and 46 on the plot 40) is calculated. As will be clear from the plot 40, at the point in time 50 at which the calculation is made, the test count value lags behind the reference count value by just under three (thus corresponding to just under three clock cycles). As such, in the notation of the pseudocode above, abs(*ref_count - test_count*) corresponds to abs(0 - -2) = +2. In this particular embodiment, the predetermined error threshold *(tol,* in the pseudocode above) is set to 3. abs(*ref_count - test_count*) is less than *tol,* so CLK_ERROR is retained at 0 (or FALSE) and an error signal is not triggered on the error signal line.

Accordingly, the error chart 48 shows that the error signal on the error signal line is generally in a low, off, FALSE state throughout the comparison step. In the second scenario shown in figure 5 therefore, an error signal is not triggered because the frequency drift is not sufficiently great to cause a difference in the reference count value and test count values that is greater than the predetermined error threshold.

Using the equation above, we can determine that if $f = 20$MHz, $N = 8$, and $\Delta Counters = -2$, then we determine that $\Delta f = 0.15625$ MHz. That is to say, the clock frequency of the test signal is $(20 - 0.15635)$ MHz = 19.84375 MHz. In the second scenario, the test clock frequency is offset by approximately -1.0%, relative to the reference clock frequency.

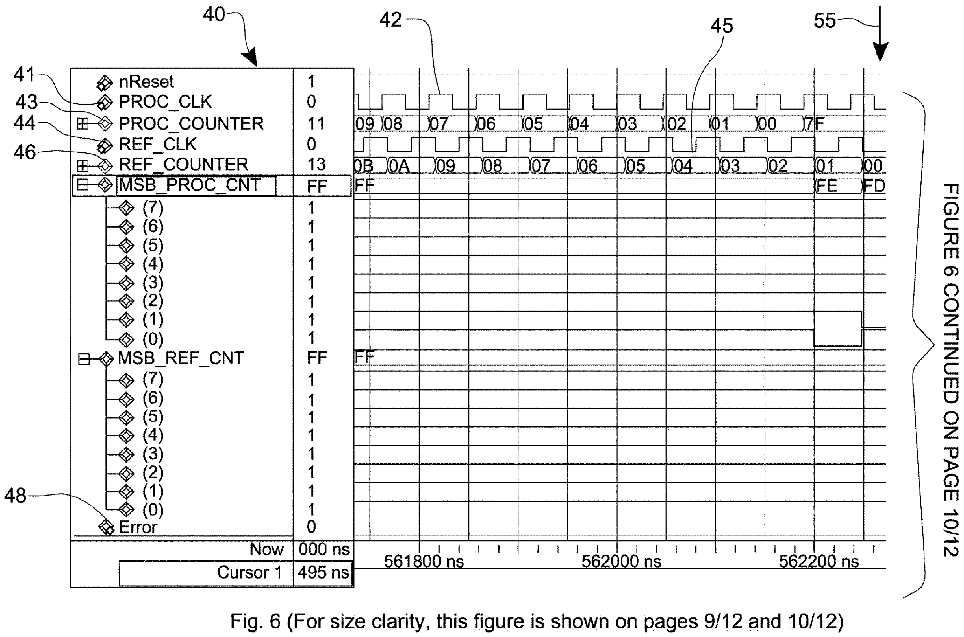

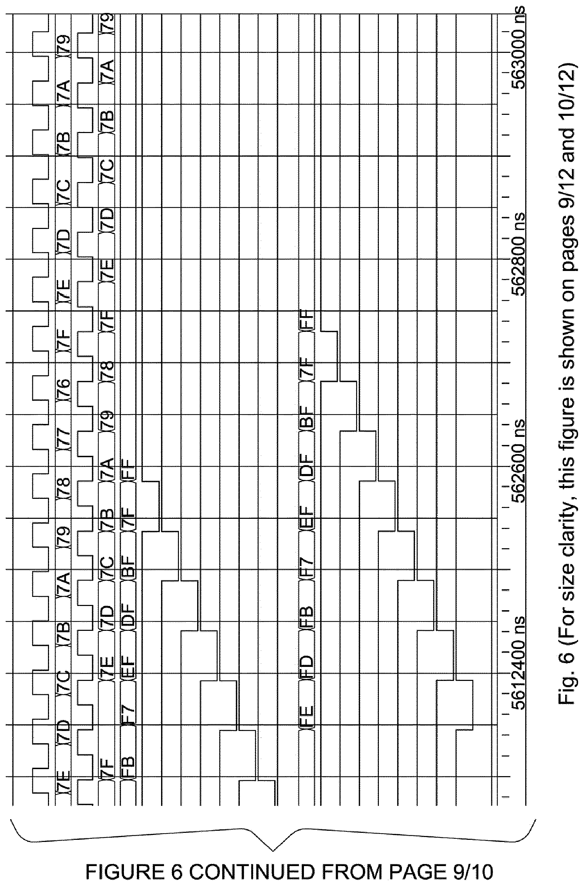

Figure 6 shows a visual representation of the comparison step and the variables involved in a third scenario. Like elements are labelled similarly to those shown in figures 4 and 5.

When the reference count is equal to the predetermined trigger value, as indicated by the point in time 55, the difference between the reference count value and the test count value (as shown in sequences 43 and 46 on the plot 40) is calculation. As will be clear from the plot 40, at the point in time 50 at which the calculation is made, the test count value is ahead of the reference count value by just under three (thus corresponding to just under three clock cycles). As such, in the notation of the pseudocode above, abs(*ref_count - test_count*) corresponds to abs(0 - +2) = +2. In this particular embodiment, the predetermined error threshold *(tol,* in the pseudocode above) is set to 3. abs(*ref_count - test_count)* is less than *tol,* so CLK_ERROR is retained at 0 (or FALSE) and an error signal is not triggered on the error signal line.

Accordingly, the error chart 48 shows that the error signal on the error signal line is generally in a low, off, FALSE state throughout the comparison step. In the third scenario shown in figure 6 therefore, an error signal is not triggered because the frequency drift is not sufficiently great to cause a difference in the reference count value and test count values that is greater than the predetermined error threshold.

Using the equation above, we can determine that if $f = 20$MHz, $N = 8$, and $\Delta Counters = +2$, then we determine that $\Delta f = 0.15625$ MHz. That is to say, the clock frequency of the test clock is $(20 + 0.15635)$ MHz = 20.15635 MHz. In the third scenario, the test clock frequency offset is approximately +1.0%, relative to the reference clock frequency.

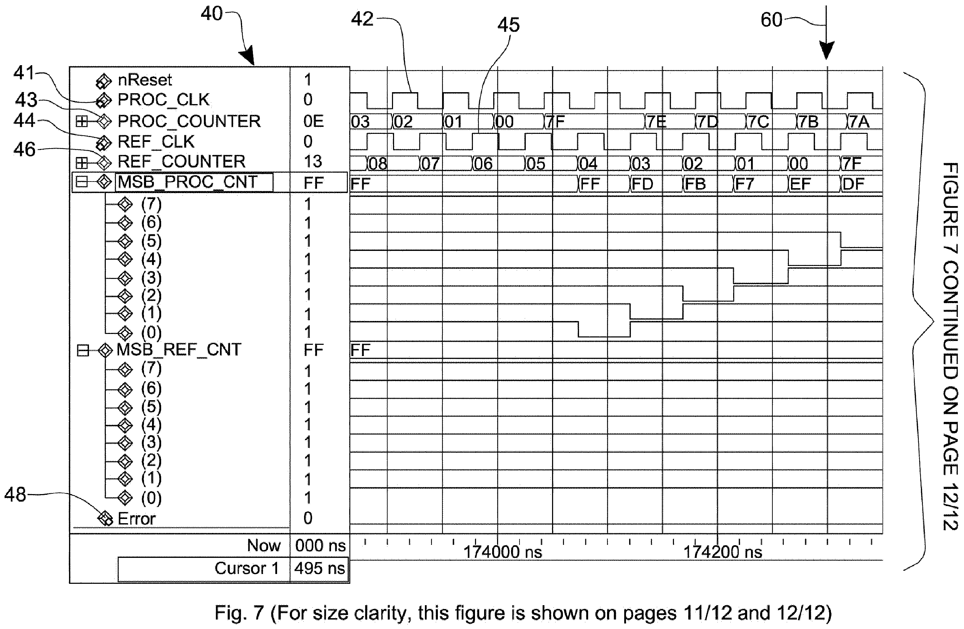

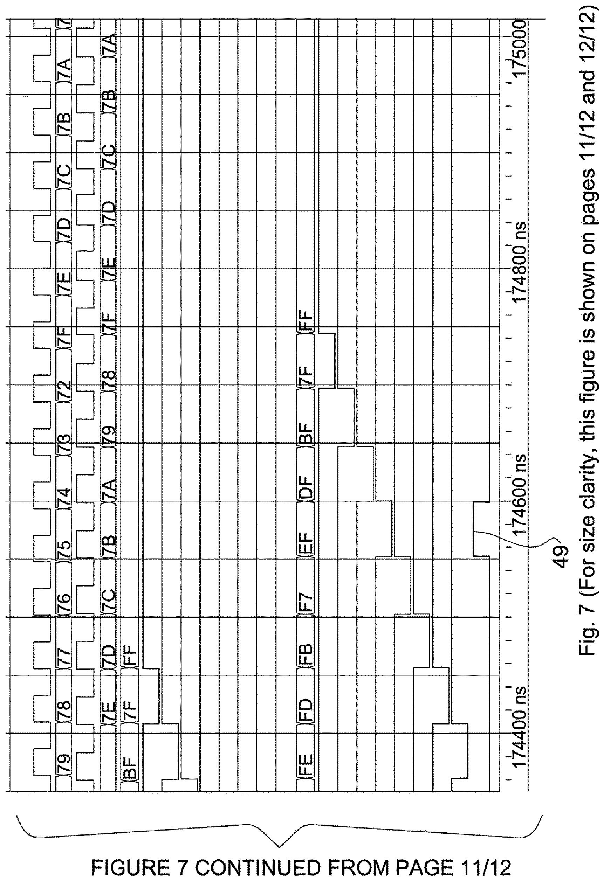

Figure 7 shows a visual representation of the comparison step and the variables involved during a fourth scenario. Like elements are labelled similarly to those shown in figures 4, 5, and 6.

When the reference count is equal to the predetermined trigger value, as indicated by the point in time 60, the difference between the reference count value and the test count value (as shown in sequences 43 and 46 on the plot 40) is calculated. As will be clear from the plot 40, at the point in time 60 at which the comparison is made, the test count value is ahead of the reference count value by just over four (thus corresponding to four clock cycles). As such, in the notation of the pseudocode above, abs(*ref_count - test_count)* corresponds to abs(0 - +4) = +4. In this particular embodiment, the predetermined error threshold *(tol,* in the pseudocode above) is set to 3. abs(*ref_count - test_count)* is greater than *tol,* so CLK_ERROR is set to 1 (or TRUE) and an error signal is triggered.

The signal on the error signal line is generally in a low, off, FALSE state, except at around 174600 nanoseconds, where the error signal 49 is output on the error signal line. The error signal corresponds to a period of time during which the signal on the error signal line is in a high, on, TRUE state. The error signal is triggered because the frequency drift is sufficiently high to cause a difference in the reference count value and test count values that is greater than the predetermined error threshold.

Using the equation above, we can determine that if $f = 20$MHz, $N = 8$, and $\Delta Counters = +4$, then we determine that $\Delta f = 0.3125$ MHz. That is to say, the clock frequency of the test clock is $(20 + 0.3125)$ MHz = 20.3125 MHz. In the fourth scenario, the test clock frequency offset is approximately +1.5%, relative to the reference clock frequency.

It will be appreciated that the comparing device could further counters, each of which counts the cycles of a clock of a respective further slave MCU/processor. Each counter can be compared to the reference counter to ensure that the frequency of the clock of the respective further slave processor is within the predetermined error threshold. In this manner, an automotive safety electronic control system, utilising a master MCU and a plurality of slave MCUs/processors, can effectively monitor the clock frequencies of the plurality of slave MCUs/processors. In this case, the error signal may be a message that includes at least an identifier of the slave processor that has triggered the error signal. A master MCU may have a single pin connected to each of error signal lines of the further slave MCUs. Alternatively, the master MCU have a separate pin for each clock error signal from each of the further slave MCUs.

When used in this specification and claims, the terms "comprises" and "comprising" and variations thereof mean that the specified features, steps or integers are included. The terms are not to be interpreted to exclude the presence of other features, steps or integers.

The features disclosed in the foregoing description, or in the following claims, or in the accompanying drawings, expressed in their specific forms or in terms of a means for performing the disclosed function, or a method or process for obtaining the disclosed results, as appropriate, may, separately, or in any combination of such features, be utilised for realising the invention in diverse forms thereof.

While the invention has been described in conjunction with the exemplary embodiments described above, many equivalent modifications and variations will be apparent to those skilled in the art when given this disclosure. Accordingly, the exemplary embodiments of the invention set forth above are considered to be illustrative and not limiting.

**Claims**

1. An automotive safety electronic control system, comprising:

   a processor (10) including a processor clock (4M), wherein the processor is configured to output a cyclic test clock signal (18) representative of the processor clock;
   a reference clock source (23) configured to output a cyclic reference clock signal, and;
   a test device (16);
   wherein the test device is configured to:

   include a test counter (20), the test counter configured to count a number of cycles of the test clock signal, and to store a test count value representing a number of test count cycles;
   include a reference counter (21), the reference counter configured to count a number of cycles of the reference clock signal, and to store a reference count value representing a number of reference count cycles, and;
   modify the test count value upon receipt by the test device of each cycle of the test clock signal;
   modify the reference count value upon receipt by the test device of each cycle of the reference clock signal, and;
   calculate a difference between the test count value and the reference count value.

2. A control system according to claim 1, wherein the modification of the reference count value and the modification of the test count value are both an increment operation or are both a decrement operation.

3. A control system according to claim 1 or claim 2, wherein the test device is configured to calculate the difference between the test count value and the reference count value when the reference count value is equal to a predetermined trigger value.

4. A control system according to any preceding claim, wherein the test device is configured to output an error signal when the absolute value of the difference between the test count value and the reference count value is greater than a predetermined error threshold.

5. A control system according to claim 4, wherein the processor is configured to perform an error recovery routine in response to the error signal.

6. A control system according to any preceding claim, wherein the test count value changes between a minimum value and a maximum value, and the reference count value changes between the minimum value and the maximum value.

7. A control system according to any preceding claim, wherein the test device includes a first input pin for receipt of the test clock signal; a second input pin for the receipt of reference clock signal; a reset pin for resetting the test device; and an error pin for outputting the error signal.

8. A control system according to any preceding claim, wherein the test device is a programmable logic device.

9. A control system according to claim 8, wherein the programmable logic device is a Complex Programmable Logic Device ("CPLD") or a Field-Programmable Gate Array ("FPGA").

10. A control system according to any preceding claim, wherein the processor is a slave processor operatively connected to a master processor, and wherein the reference clock source is included within the master processor.

11. A control system according to any one of claims 1-9, wherein the processor is a slave processor operatively connected to a master processor, wherein a processor reference clock source is included within the master processor and an oscillator reference clock source is a local oscillator,
and wherein the test device is configured to use interchangeably the processor reference clock source or the oscillator reference clock source as the reference clock source.

**12.** A control system according to any preceding claim, wherein the difference between the test count value and the reference count value represents a difference in the clock frequency of the processor clock and a clock frequency of the reference clock.

**13.** A control system according to any preceding claim, including at least one further processor; each further processor including a respective clock, wherein each further processor is configured to output a respective cyclic test clock signal representative of the respective clock;
and wherein the test device is further configured to:

include at least one further test counter, the further test counter configured to count a number of cycles of the respective test clock signal, and to store a further test count value representing a number of further test count cycles;
modify each further test count value upon receipt of each cycle of the respective test clock signal;
calculate a difference between each respective test count value and the reference count value.

**14.** A control system according to claim 13, wherein the test device is configured to output a respective error signal if the difference between a respective test count value and the reference count value is greater than a respective error threshold.

**15.** A control system according to claim 14, wherein each respective slave processor is configured to receive the respective error signal, and, upon receipt of the respective error signal, perform an error recovery routine.

**Patentansprüche**

**1.** Elektronisches Automobilsicherheitssteuersystem, das Folgendes umfasst:

einen Prozessor (10), der einen Prozessorzeitgeber (4M) umfasst, wobei der Prozessor ausgelegt ist, um ein periodisches Testtaktsignal (18) auszugeben, das den Prozessorzeitgeber repräsentiert;
eine Referenztaktquelle (23), die ausgelegt ist, um ein periodisches Referenztaktsignal auszugeben, und eine Testvorrichtung (16),
wobei die Testvorrichtung ausgelegt ist, um:

einen Testzähler (20) zu umfassen, wobei der Testzähler ausgelegt ist, um eine Anzahl von Perioden des Testtaktsignals zu zählen und einen Testzählwert, der für eine Anzahl von Testzählperioden steht, zu speichern;
einen Referenzzähler (21) zu umfassen, wobei der Referenzzähler ausgelegt ist, um eine Anzahl von Perioden des Referenztaktsignals zu zählen und einen Referenzzählwert, der für eine Anzahl von Referenzzählperioden steht, zu speichern, und
den Testzählwert bei Empfang von jeder Periode des Testtaktsignals durch die Testvorrichtung zu modifizieren;
den Referenzzählwert bei Empfang von jeder Periode des Referenztaktsignals durch die Testvorrichtung zu modifizieren, und
eine Differenz zwischen dem Testzählwert und dem Referenzzählwert zu berechnen.

**2.** Steuersystem nach Anspruch 1, wobei das Modifizieren des Referenzzählwerts und das Modifizieren des Testzählwerts beides ein Inkrementvorgang oder beides ein Dekrementvorgang ist.

**3.** Steuersystem nach Anspruch 1 oder 2, wobei die Testvorrichtung ausgelegt ist, um die Differenz zwischen dem Testzählwert und dem Referenzzählwert zu berechnen, wenn der Referenzzählwert gleich einem vorbestimmten Auslösewert ist.

**4.** Steuersystem nach einem der vorangegangenen Ansprüche, wobei die Testvorrichtung ausgelegt ist, um ein Fehlersignal auszugeben, wenn der Absolutwert der Differenz zwischen dem Testzählwert und dem Referenzzählwert größer als ein vorbestimmter Fehlerschwellenwert ist.

**5.** Steuersystem nach Anspruch 4, wobei der Prozessor ausgelegt ist, um eine Fehlerbehebungsroutine als Antwort auf das Fehlersignal durchzuführen.

6. Steuersystem nach einem der vorangegangenen Ansprüche, wobei der Testzählwert sich zwischen einem Mindestwert und einem Maximalwert ändert und der Referenzzählwert sich zwischen dem Mindestwert und dem Maximalwert ändert.

7. Steuersystem nach einem der vorangegangenen Ansprüche, wobei die Testvorrichtung einen ersten Eingabeanschluss zum Empfang des Testtaktsignals, einen zweiten Eingabeanschluss zum Empfang des Referenztaktsignals, einen Rückstellanschluss zum Rückstellen der Testvorrichtung und einen Fehleranschluss zur Ausgabe des Fehlersignals umfasst.

8. Steuersystem nach einem der vorangegangenen Ansprüche, wobei die Testvorrichtung eine programmierbare Logikvorrichtung ist.

9. Steuersystem nach Anspruch 8, wobei die programmierbare Logikvorrichtung eine Complex Programmable Logic Device ("CPLD") oder ein Field-Programmable Gate-Array ("FPGA") ist.

10. Steuersystem nach einem der vorangegangenen Ansprüche, wobei der Prozessor ein Slave-Prozessor ist, der mit einem Master-Prozessor wirkverbunden ist, und wobei die Referenztaktquelle Teil des Master-Prozessors ist.

11. Steuersystem nach einem der Ansprüche 1 bis 9, wobei der Prozessor ein Slave-Prozessor ist, der mit einem Master-Prozessor wirkverbunden ist, wobei eine Prozessorreferenztaktquelle Teil des Master-Prozessors ist und eine Oszillatorreferenztaktquelle ein lokaler Oszillator ist, und wobei die Testvorrichtung ausgelegt ist, um die Prozessorreferenztaktquelle oder die Oszillatorreferenztaktquelle austauschbar als Referenztaktquelle zu nutzen.

12. Steuersystem nach einem der vorangegangenen Ansprüche, wobei die Differenz zwischen dem Testzählwert und dem Referenzzählwert eine Differenz der Taktfrequenz des Prozessorzeitgebers und einer Taktfrequenz des Referenzzeitgebers darstellt.

13. Steuersystem nach einem der vorangegangenen Ansprüche, das zumindest einen weiteren Prozessor umfasst; wobei jeder weitere Prozessor einen entsprechenden Taktgeber umfasst, wobei jeder weitere Prozessor ausgelegt ist, um ein entsprechendes periodisches Testtaktsignal auszugeben, das den entsprechenden Takt repräsentiert; und wobei die Testvorrichtung ferner ausgelegt ist, um:

zumindest einen weiteren Testzähler zu umfassen, wobei der weitere Testzähler ausgelegt ist, um eine Anzahl von Perioden des entsprechenden Testtaktsignals zu zählen und einen weiteren Testzählwert, der für eine Anzahl von weiteren Testzählperioden steht, zu speichern;
jeden weiteren Testzählwert bei Empfang von jeder Periode des entsprechenden Testtaktsignals zu modifizieren;
eine Differenz zwischen jedem entsprechenden Testzählwert und dem Referenzzählwert zu berechnen.

14. Steuersystem nach Anspruch 13, wobei die Testvorrichtung ausgelegt ist, um ein entsprechendes Fehlersignal auszugeben, wenn die Differenz zwischen einem entsprechenden Testzählwert und dem Referenzzählwert größer ist als ein entsprechender Fehlerschwellenwert.

15. Steuersystem nach Anspruch 14, wobei jeder entsprechende Slave-Prozessor ausgelegt ist, um das entsprechende Fehlersignal zu empfangen und bei Empfang des entsprechenden Fehlersignals eine Fehlerbehebungsroutine durchzuführen.

**Revendications**

1. Système de commande électronique de sécurité automobile, comprenant :

un processeur (10) comprenant une horloge de processeur (4M), dans lequel le processeur est configuré pour délivrer en sortie un signal d'horloge test cyclique (18) représentatif de l'horloge de processeur ;
une source d'horloge de référence (23) configurée pour délivrer en sortie un signal d'horloge de référence cyclique, et ;
un dispositif de test (16) ;
dans lequel le dispositif de test est configuré pour :

inclure un compteur de test (20), le compteur de test étant configuré pour compter un nombre de cycles du signal d'horloge test, et pour stocker une valeur de compte de test représentant un nombre de cycles de compte de test ;

inclure un compteur de référence (21), le compteur de référence étant configuré pour compter un nombre de cycles du signal d'horloge de référence, et pour stocker une valeur de compte de référence représentant un nombre de cycles de compte de référence, et ;

modifier la valeur de compte de test lors de la réception par le dispositif de test de chaque cycle du signal d'horloge test ;

modifier la valeur de compte de référence lors de la réception par le dispositif de test de chaque cycle du signal d'horloge de référence, et ;

calculer une différence entre la valeur de compte de test et la valeur de compte de référence.

2. Système de commande selon la revendication 1, dans lequel la modification de la valeur de compte de référence et la modification de la valeur de compte de test sont toutes deux une opération d'incrémentation ou sont toutes deux une opération de décrémentation.

3. Système de commande selon la revendication 1 ou la revendication 2, dans lequel le dispositif de test est configuré pour calculer la différence entre la valeur de compte de test et la valeur de compte de référence lorsque la valeur de compte de référence est égale à une valeur de déclenchement prédéterminée.

4. Système de commande selon une quelconque revendication précédente, dans lequel le dispositif de test est configuré pour délivrer en sortie un signal d'erreur lorsque la valeur absolue de la différence entre la valeur de compte de test et la valeur de compte de référence est supérieure à un seuil d'erreur prédéterminé.

5. Système de commande selon la revendication 4, dans lequel le processeur est configuré pour effectuer une routine de récupération d'erreur en réponse au signal d'erreur.

6. Système de commande selon une quelconque revendication précédente, dans lequel la valeur de compte de test change entre une valeur minimale et une valeur maximale, et la valeur de compte de référence change entre la valeur minimale et la valeur maximale.

7. Système de commande selon une quelconque revendication précédente, dans lequel le dispositif de test comprend une première broche d'entrée pour la réception du signal d'horloge test ; une seconde broche d'entrée pour la réception du signal d'horloge de référence ; une broche de réinitialisation pour réinitialiser le dispositif de test ; et une broche d'erreur pour délivrer en sortie le signal d'erreur.

8. Système de commande selon une quelconque revendication précédente, dans lequel le dispositif de test est un dispositif logique programmable.

9. Système de commande selon la revendication 8, dans lequel le dispositif logique programmable est un Dispositif Logique Programmable Complexe (« CPLD ») ou un Réseau de Portes Programmables sur Site (« FPGA »).

10. Système de commande selon une quelconque revendication précédente, dans lequel le processeur est un processeur esclave connecté de manière opérationnelle à un processeur maître, et dans lequel la source d'horloge de référence est incluse dans le processeur maître.

11. Système de commande selon une quelconque des revendications 1 à 9, dans lequel le processeur est un processeur esclave connecté de manière opérationnelle à un processeur maître, dans lequel une source d'horloge de référence de processeur est incluse dans le processeur maître et une source d'horloge de référence d'oscillateur est un oscillateur local,

et dans lequel le dispositif de test est configuré pour utiliser de manière interchangeable la source d'horloge de référence de processeur ou la source d'horloge de référence d'oscillateur comme source d'horloge de référence.

12. Système de commande selon une quelconque revendication précédente, dans lequel la différence entre la valeur de compte de test et la valeur de compte de référence représente une différence de la fréquence d'horloge de l'horloge de processeur et une fréquence d'horloge de l'horloge de référence.

13. Système de commande selon une quelconque revendication précédente, comprenant au moins un processeur supplémentaire ; chaque processeur supplémentaire comprenant une horloge respective, dans lequel chaque processeur supplémentaire est configuré pour délivrer en sortie un signal d'horloge test cyclique respectif représentatif de l'horloge respective ;
et dans lequel le dispositif de test est configuré pour :

inclure au moins un compteur test supplémentaire, le compteur test supplémentaire étant configuré pour compter un nombre de cycles du signal d'horloge test respectif, et pour stocker une valeur de compte test supplémentaire représentant un nombre de cycles de compte de test supplémentaire ;
modifier chaque valeur de compte de test supplémentaire lors de la réception de chaque cycle du signal d'horloge test respectif ;
calculer une différence entre chaque valeur de compte de test respective et la valeur de compte de référence.

14. Système de commande selon la revendication 13, dans lequel le dispositif de test est configuré pour délivrer en sortie un signal d'erreur respectif si la différence entre une valeur de compte de test respective et la valeur de compte de référence est supérieure à un seuil d'erreur respectif.

15. Système de commande selon la revendication 14, dans lequel chaque processeur esclave respectif est configuré pour recevoir le signal d'erreur respectif, et, lors de la réception du signal d'erreur respectif, effectuer une routine de récupération d'erreur.

Fig. 1A

Fig. 1B

Fig. 2

Fig. 3

Fig. 4 (For size clarity, this figure is shown on pages 5/12 and 6/12)

EP 3 385 728 B1

Fig. 4 (For size clarity, this figure is shown on pages 5/12 and 6/12)

FIGURE 4 CONTINUED FROM PAGE 5/12

FIGURE 5 CONTINUED ON PAGE 8/12

Fig. 5 (For size clarity, this figure is shown on pages 7/12 and 8/12)

Fig. 5 (For size clarity, this figure is shown on pages 7/12 and 8/12)

FIGURE 5 CONTINUED FROM PAGE 7/12

Fig. 6 (For size clarity, this figure is shown on pages 9/12 and 10/12)

Fig. 6 (For size clarity, this figure is shown on pages 9/12 and 10/12)

FIGURE 6 CONTINUED FROM PAGE 9/10

EP 3 385 728 B1

| Signal | Value | | | | | | | | | | |
|---|---|---|---|---|---|---|---|---|---|---|---|
| nReset | 1 | | | | | | | | | | |
| PROC_CLK | 0 | | | | | | | | | | |
| PROC_COUNTER | 0E | 03 | 02 | 01 | 00 | 7F | 7E | 7D | 7C | 7B | 7A |
| REF_CLK | 0 | | | | | | | | | | |
| REF_COUNTER | 13 | 08 | 07 | 06 | 05 | 04 | 03 | 02 | 01 | 00 | 7F |
| MSB_PROC_CNT | FF | FF | | | | FF | FD | FB | F7 | EF | DF |
| (7) | 1 | | | | | | | | | | |
| (6) | 1 | | | | | | | | | | |
| (5) | 1 | | | | | | | | | | |
| (4) | 1 | | | | | | | | | | |
| (3) | 1 | | | | | | | | | | |
| (2) | 1 | | | | | | | | | | |
| (1) | 1 | | | | | | | | | | |
| (0) | 1 | | | | | | | | | | |
| MSB_REF_CNT | FF | FF | | | | | | | | | |
| (7) | 1 | | | | | | | | | | |
| (6) | 1 | | | | | | | | | | |
| (5) | 1 | | | | | | | | | | |
| (4) | 1 | | | | | | | | | | |
| (3) | 1 | | | | | | | | | | |
| (2) | 1 | | | | | | | | | | |
| (1) | 1 | | | | | | | | | | |
| (0) | 1 | | | | | | | | | | |
| Error | 0 | | | | | | | | | | |
| Now | 000 ns | | | | 174000 ns | | | | 174200 ns | | |
| Cursor 1 | 495 ns | | | | | | | | | | |

Fig. 7 (For size clarity, this figure is shown on pages 11/12 and 12/12)

Fig. 7 (For size clarity, this figure is shown on pages 11/12 and 12/12)

FIGURE 7 CONTINUED FROM PAGE 11/12

**EP 3 385 728 B1**

**Patent documents cited in the description**

- US 2013191065 A